# EUROPÄISCHE PATENTSCHRIFT

(11) **EP 3 091 663 B1**
(45) Veröffentlichungstag und Bekanntmachung des Hinweises auf die Patenterteilung: **20.09.2017**
(21) Anmeldenummer: 16164732.6
(22) Anmeldetag: 11.04.2016
(51) Int. Cl.: H03K 17/95

(54) **ELEKTROMAGNETISCHER NÄHERUNGSSENSOR UND VERFAHREN ZUR ERFASSUNG EINES ZIELOBJEKTS**
ELECTROMAGNETIC PROXIMITY SENSOR AND A METHOD FOR DETECTING A TARGET OBJECT
CAPTEUR DE PROXIMITE ELECTROMAGNETIQUE ET PROCEDE DE DETECTION D'UN OBJET CIBLE

(30) Priorität: 08.05.2015 DE 102015107221
(43) Veröffentlichungstag der Anmeldung: 09.11.2016
(73) Patentinhaber: SICK AG, 79183 Waldkirch (DE)
(72) Erfinder: Paschke, Marc, 79232 March (DE); Thoss, Dr. Sascha, 79106 Freiburg (DE)

(56) Entgegenhaltungen:
- FR-A1- 2 985 034
- US-A1- 2009 289 818
- US-A1- 2015 049 057
- US-A1- 2015 061 656

## Beschreibung

Die Erfindung betrifft einen elektromagnetischen Näherungssensor und ein Verfahren zur Erfassung eines Zielobjekts nach dem Oberbegriff von Anspruch 1 beziehungsweise 8.

Näherungssensoren erkennen die Anwesenheit oder Annäherung von Objekten bei einem Schaltabstand. Das Objekt wird in diesem Zusammenhang häufig als Target oder Ziel bezeichnet. Je nach Technologie werden Ziele mit bestimmten Eigenschaften erkannt. Beispielsweise erkennt ein induktiver Näherungssensor leitende, in der Praxis vor allem metallische Ziele, während ein kapazitiver Näherungssensor auf dielektrische Eigenschaften reagiert. Näherungssensoren werden sehr oft als berührungslose Schalter eingesetzt, mit einem Schaltzustand bei Anwesenheit und dem anderen Schaltzustand bei Abwesenheit eines Ziels im Schaltabstand.

Die Näherungssensoren sind dabei häufig einer rauen Umgebung mit hohen Temperaturschwankungen, Verschmutzung und Verschleiß vor allem des zu detektierenden Objekts durch mechanische Beanspruchung ausgesetzt, was auch noch Alterungserscheinungen des Sensors verstärkt. Solche Effekte werden zusammenfassend als Driften bezeichnet. Ein weiteres Problem stellen die sogenannten Einbaubedingungen dar. Ein induktiver Sensor reagiert auf alle metallischen Objekte in seiner Nähe, nicht nur auf das zu erfassende Objekt. Ein kapazitiver Sensor wird auch durch die dielektrischen Eigenschaften der Umgebung beeinflusst. Ähnliche Effekte gibt es auch bei magnetischen Sensoren oder Mikrowellensensoren. Deshalb verändert sich der Schaltabstand unter Umständen in einer neuen Umgebung oder aufgrund von Driften sehr stark, der als Schalter eingesetzte Sensor geht also in der Praxis nicht mehr aus oder schaltet nicht mehr ein. Das Problem verstärkt sich bei großen Schaltabständen, weil dann die Empfindlichkeit der Sensoren zunimmt.

Herkömmliche Näherungssensoren haben einen festen Schaltabstand und stellen darüber hinaus keine Information über den Abstand des erfassten Objekts zur Verfügung. Von den Driften wird typischerweise nur die Temperatur berücksichtigt, und zwar in einer klassischen Temperaturkompensation durch Messung der Temperatur und Verwendung einer Korrekturtabelle. Das ist fehlerbehaftet, weil die Temperatur der Messelektronik nicht der Temperatur des eigentlichen Sensorelements entspricht, beispielsweise der Sensorspule eines induktiven Sensors. Die übrigen genannten Effekte werden gar nicht kompensiert.

Für optische Sensoren ist aus der DE 10 2011 050 119 A1 bekannt, aus einer Zeitreihe des Empfangssignals zumindest die beiden ersten Momente der Verteilung zu bestimmen, daraus einen Zustand zu klassifizieren und daraus ein Schaltsignal abzuleiten. Lösungen von optischen Sensoren können aber nicht ohne Weiteres auf die hier betrachteten Näherungssensoren übertragen werden. Das Lichtsignal des optischen Sensors weist keine vergleichbare Abstandsabhängigkeit auf, und solche Sensoren haben daher keinen Schaltabstand. Das bedeutet nicht, dass ein optischer Sensor keine Abstände messen und bei bestimmten Abständen schalten könnte, aber eine optische Abstandsmessung erfolgt auf gänzlich andere Weise beispielsweise durch Triangulation oder Lichtlaufzeitbestimmung und hängt nicht mit der Intensität des Sensorsignals zusammen.

Aus der FR 2 985 034 A1 ist ein Verfahren zum kontinuierlichen Messen eines Magnetfeldes durch einen Sensor bekannt. Der Sensor erkennt mittels Schwellbewertung des zu- und abnehmenden Magnetfeldes das Durchfahren der Zähne eines Zahnrads. Die Schwelle wird anhand des maximalen und minimalen Signals angepasst.

Die US 2015/061656 A1 offenbart eine Schaltung für einen Magnetfeldsensor zur Erkennung von Objektbewegungen, insbesondere der Zähne eines Zahnrads. Während der Umdrehungen kann eine Schwelle zur Bewertung des Sensorsignals angepasst, beispielsweise auf die Mitte zwischen Maximum und Minimum des Sensorsignals gelegt werden.

Die US 2009/289818 A1 beschreibt eine kapazitive Tastatur für ein Mobiltelefon. Es wird ein Signal erzeugt, welches das Drücken einer Taste durch einen Benutzer beschreibt. In der Ableitung dieses Signals wird ein Maximum identifiziert und daraus eine Kapazität während des Tastendrucks bestimmt. Eine Auslöseschwelle für die Taste wird zwischen die derart bestimmte Kapazität und die Kapazität in einer Ruhestellung gelegt.

Die US 2015/049057 A1 befasst sich mit einer Filterung für einen kapazitiven Sensor. Dazu wird die Fourier- oder Hadamardtransformierte der kapazitiven Rohdaten bestimmt. Es wird dann unter anderem vorgeschlagen, eine Berührung oder ein Loslassen durch Untersuchung von Steigungen festzustellen.

Es ist daher Aufgabe der Erfindung, das Schaltverhalten eines elektromagnetischen Näherungssensors robuster zu machen.

Diese Aufgabe wird durch einen elektromagnetischen Näherungssensor und ein Verfahren zur Erfassung eines Zielobjekts nach Anspruch 1 beziehungsweise 8 gelöst. Ein elektromagnetischer Näherungssensor erzeugt mit einem Sensorelement ein vom Abstand eines Zielobjekts abhängiges Sensorsignal und wertet dies mit einer Schaltschwelle aus, um Anwesenheit des Zielobjekts in einem Schaltabstand festzustellen. Die Erfindung geht nun von dem Grundgedanken aus, die Schaltschwelle an einen sich durch Driften verändernden Pegel des Sensorsignals anzupassen. Dazu wird ein Anwesenheitspegel gemessen, während das Zielobjekt als anwesend erkannt ist, beziehungsweise ein Abwesenheitspegel, wenn kein Zielobjekt das Sensorsignal beeinflusst. Änderungen von Anwesenheits- oder Abwesenheitspegel sind dann nicht dem Abstand des Zielobjekts, sondern den Driften geschuldet, und dementsprechend können die Driften durch Anpassung der Schaltschwelle kompensiert werden. Es ist zu beachten, dass die für die Kompensation erkannte Anwesenheit und Abwesenheit nicht gleichzusetzen ist mit den beiden Schaltzuständen. Beispielsweise beeinflusst ein Objekt in etwas größerer Entfernung als der Schaltabstand durchaus noch das Sensorsignal, d. h. es ist noch anwesend im Sinne der Driftkompensation, nicht aber im Sinne des Schaltzustands.

Die Erfindung hat den Vorteil, dass ein ungewolltes Verschieben des Schaltabstands und insbesondere ein Funktionsausfall verhindert wird. Der Sensor bleibt dadurch auch in rauen Umgebungen zuverlässig einsatzfähig. Es wird eine Kompensation von Driften wie Verschleiß- und Alterungserscheinungen an dem Sensor oder dessen Halterung, Verschmutzung oder Temperaturschwankungen und eine Anpassung an Abweichungen vom Normeinbau beziehungsweise Änderungen der Einbauumgebung insbesondere während der Laufzeit ermöglicht.

Vorzugsweise umfasst das Sensorelement eine Sendespule mit einer Erregerschaltung und eine Empfangsspule, wobei das Sensorsignal aus der Spannung über der Empfangsspule abgeleitet ist, oder das Sensorelement weist einen Schwingkreis mit einer Spule auf, wobei das Sensorsignal aus der Spannung über dem Schwingkreis abgeleitet ist. Dies sind bewährte Arbeitsprinzipien eines induktiven Näherungsschalters. Die Spannung in der Empfangsspule beziehungsweise in dem Schwingkreis sinkt durch in einem Zielobjekt induzierte Wirbelströme ab, wobei dieser Effekt sich mit zunehmender Nähe des Zielobjekts erhöht.

Die Auswertungseinheit ist bevorzugt dafür ausgebildet, die Schaltschwelle entsprechend den Änderungen des Abwesenheitspegels anzupassen. Die Schaltschwelle wird also entsprechend einer Drift des Abwesenheitspegels nachgeführt. Dadurch bleibt der Schaltabstand trotz Driften konstant. Dieses Vorgehen wird auch als Autokorrektur bezeichnet. Einflüsse der Driften auf den Schaltabstand des Sensors sind eliminiert, und dadurch erhöht sich die Verfügbarkeit und Robustheit der Erfassung enorm.

In einer alternativen vorteilhaften Ausführungsform ist die Auswertungseinheit dafür ausgebildet, die Schaltschwelle bei einer Anpassung mit großem Störabstand zu Abwesenheitspegel und Anwesenheitspegel neu festzulegen, insbesondere auf deren Mittelwert. Hierbei geht es nicht darum, den Schaltabstand konstant zu halten, sondern der Sensor setzt seine Schaltschwelle und damit seinen Schaltabstand so fest, dass ein besonders robustes Schaltverhalten sichergestellt ist, das eine maximale Störunempfindlichkeit erlaubt. Dieses Vorgehen wird auch als Autodetektion bezeichnet. Ein solcher Sensor hat keinen festen Schaltabstand mehr, und damit muss der Schaltabstand auch nicht mehr eingestellt werden. Der Sensor besitzt lediglich noch einen maximal möglichen Erfassungsbereich. Dadurch verringert sich die Varianz der Sensormodelle erheblich, mit entsprechenden Kostenvorteilen bei Hersteller und Kunde.

Die Auswertungseinheit ist bevorzugt dafür ausgebildet, einen zeitlichen Verlauf des Sensorsignals mit einem Referenzverlauf während einer erwarteten Bewegung des Zielobjekts zu vergleichen und so Zeitpunkte zur Erfassung des Abwesenheitspegels und/oder des Anwesenheitspegels zu bestimmen. In wichtigen Anwendungen wiederholt sich die Annäherungsbewegung des Zielobjekts zyklisch. Auch sonst können typische Annäherungsszenarien bekannt sein und eingelernt werden. Der Sensor erkennt durch Vergleich mit einem solchen Referenzverlauf, welche Veränderungen des Sensorsignals auf die Bewegung des Zielobjekts zurückzuführen sind. Deshalb ist der Sensor in der Lage, Zeitpunkte zu bestimmen, in denen das Zielobjekt anwesend oder abwesend ist, um die entsprechenden Pegel für die Schwellenanpassung zu bestimmen.

Die Auswertungseinheit ist bevorzugt dafür ausgebildet, Zeitpunkte zur Erfassung des Abwesenheitspegels und/oder des Anwesenheitspegels anhand einer Untersuchung der Ableitung des Sensorsignals zu bestimmen. Driften haben einen signifikant anderen Einfluss auf die Ableitung des Sensorsignals als die Bewegung des Zielobjekts. Generell sind Driften langsamer und stets gleichgerichtet wie bei Verschleiß, Alterung oder Verschmutzung, oder sie sind Einmaleffekte wie bei einem Umbau. Deshalb ermöglicht eine Betrachtung der Ableitung die Festlegung von Zeitpunkten zur Bestimmung des Abwesenheits- oder Abwesenheitspegels und verhindert insbesondere, diese Pegel gerade während einer Bewegung des Zielobjekts zu bestimmen und so die Schwelle fälschlich gemäß einer weitgehend zufälligen Position des Zielobjekts statt einer Drift anzupassen.

Die Auswertungseinheit ist bevorzugt dafür ausgebildet, das Sensorsignals auf eine erwartete zeitliche Abfolge des Vorzeichens der Ableitung zu untersuchen. Dabei müssen keine Modelle für den quantitativen Verlauf der Ableitung aufgestellt und mit schwer festzulegenden Toleranzen überprüft werden, sondern es wird lediglich eine einfache Abfolge des sehr robust bestimmbaren Vorzeichens der Ableitung überwacht. Ein Beispiel für eine Abfolge ist eine zunächst negative Ableitung, die dann direkt oder mit einem Plateau bei Ableitung Null in eine positive Ableitung übergeht und wieder auf Null abfällt. Das entspricht dann einem Targetzyklus eines sich nähernden und wieder entfernenden Zielobjekts. Wie aus dem Beispiel hervorgeht, soll der Wert Null mit samt einer gewissen Toleranzumgebung auch als ein Vorzeichen der Ableitung aufgefasst werden. Ob die Ableitung positiv oder negativ ist, hängt auch vom Sensorprinzip ab. Es wird dabei immer von einem Sensor ausgegangen, bei dem das Sensorsignal wie bei einem induktiven Sensor mit zunehmender Nähe des Zielobjekts geschwächt wird. Bei anderen Sensoren mit höherem Pegel bei nahen Zielobjekten sind die Vorzeichen entsprechend umzukehren.

Die Auswertungseinheit ist bevorzugt dafür ausgebildet, aus dem Vorzeichen der Ableitung des Sensorsignals Bedingungen für einen Zustandsübergang in einem Zustandsautomaten abzuleiten, wobei in einem ersten Zustand der Abwesenheitspegel und/oder in einem weiteren Zustand der Anwesenheitspegel bestimmt wird. Ein Targetzyklus eines Annäherns und anschließenden Sich-Entfernens eines Zielobjekts wird hierbei als Zustandsautomat beziehungsweise Klassifikator modelliert, wobei das Vorzeichen der Ableitung die Bedingung für einen Zustandsübergang oder Klassenwechsel festlegt. Ein solcher Zustandsautomat ist sehr einfach implementierbar und ermöglicht eine robuste Bestimmung von Zuständen beziehungsweise Zeitpunkten, in denen die für die Anpassung der Schwelle benötigten Abwesenheits- oder Anwesenheitspegel ermittelt werden.

Der Zustandsautomat weist bevorzugt den ersten Zustand "Warten auf Targetannäherung", den zweiten Zustand "Target nähert sich", einen dritten Zustand "Target ist da" und einen vierten Zustand "Target entfernt sich" auf, mit den Zustandsübergängen
- erster Zustand auf dritter Zustand bei negativer Ableitung
- zweiter Zustand auf dritten Zustand bei Ableitung Null
- zweiter Zustand auf vierten Zustand bei positiver Ableitung
- dritter Zustand auf vierten Zustand bei positiver Ableitung und
- vierter Zustand auf ersten Zustand bei Ableitung Null.

Dies ist ein einfacher Zustandsautomat, der dennoch die typische Erfassungssituation an einem Näherungssensor beschreibt und damit eine robuste Schwellenanpassung ermöglicht. Der Anwesenheitspegel kann im dritten Zustand gemessen werden. Es ist alternativ auch denkbar, den Anwesenheitspegel als Maximum beim Übergang vom zweiten Zustand auf den vierten Zustand zu bestimmen. Dabei kann in einigen Ausführungsformen sogar auf den dritten Zustand und die zugehörigen Bedingungen für einen Zustandsübergang verzichtet werden.

Das erfindungsgemäße Verfahren kann auf ähnliche Weise weitergebildet werden und zeigt dabei ähnliche Vorteile. Derartige vorteilhafte Merkmale sind beispielhaft, aber nicht abschließend in den sich an die unabhängigen Ansprüche anschließenden Unteransprüchen beschrieben.

Die Erfindung wird nachstehend auch hinsichtlich weiterer Merkmale und Vorteile beispielhaft anhand von Ausführungsformen und unter Bezug auf die beigefügte Zeichnung näher erläutert. Die Abbildungen der Zeichnung zeigen in:
- Fig. 1a-d: schematische Darstellungen eines Näherungssensors über einen Tar-getzyklus eines sich annähernden und wieder entfernenden Zielobjekts;
- Fig. 2: beispielhafte zeitliche Verläufe eines Sensorsignals und eines daraus mit einer Schwelle abgeleiteten Schaltsignals über mehrere Targetzyklen; und
- Fig. 3: ein beispielhaftes Zustandsdiagramm für die Erkennung eines Targetzyklus' auf Basis einer Ableitungsanalyse.

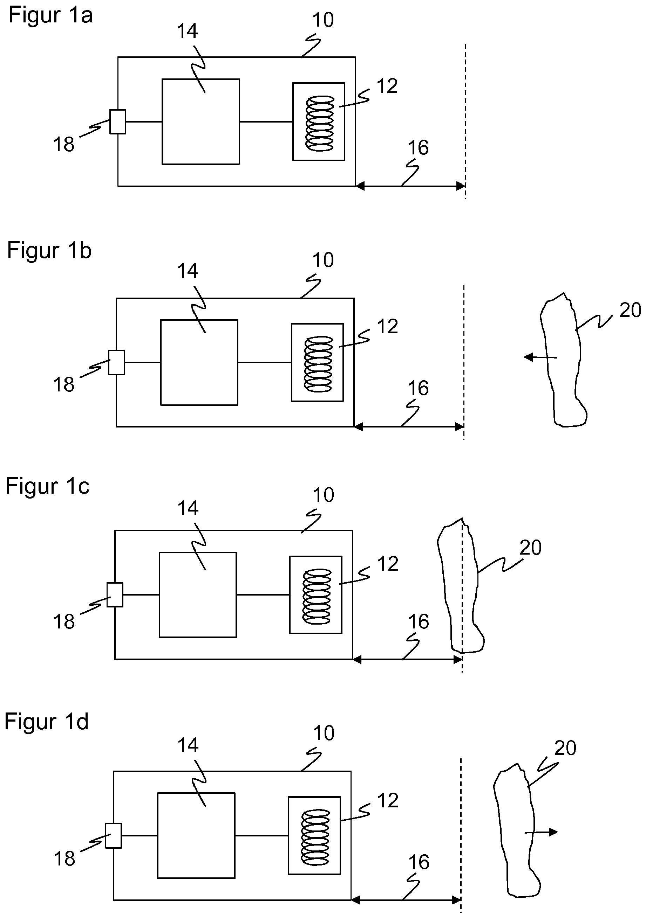

Figur 1a zeigt einen induktiven Näherungssensor 10 in einer sehr vereinfachten schematischen Darstellung. Der Näherungssensor 10 umfasst ein Sensorelement 12, das ein Sensorsignal erzeugt, welches von einer Auswertungseinheit 14 mit einer Schaltschwelle bewertet wird. Diese Schaltschwelle entspricht einem bestimmten Schaltabstand 16, der in Figur 1a durch einen Pfeil und eine gestrichelte Linie angedeutet ist. Ein Schaltausgang 18 erzeugt ein Ein- oder Ausschaltsignal je nachdem, ob das Sensorsignal über oder unter der Schwelle liegt. Dabei kann mit zwei unterschiedlichen Schwellen für Ein- und Ausschalten eine Hysterese realisiert werden.

Das Arbeitsprinzip eines induktiven Näherungssensors 10 ist an sich bekannt und wird daher nicht im Detail erläutert. Ein gängiges Prinzip ist, in dem Sensorelement 12 eine Sendespule und eine Empfangsspule unterzubringen. Eine an die Sendespule angeschlossene Erregerschaltung baut in der Sendespule ein Wechselfeld auf, welches wiederum in der Empfangsspule eine Spannung induziert. Die Auswertungseinheit 14 nutzt die Spannungsamplitude als Sensorsignal. Es gibt viele Alternativen, einen induktiven Sensor mit einer anderen Anzahl und Anordnung von Spulen aufzubauen. Beispielsweise ist ein weiteres bewährtes Prinzip das Vorsehen nur eines Schwingkreises mit einer Spule, wobei dann die Spannung über diesem Schwingkreis das Sensorsignal bildet.

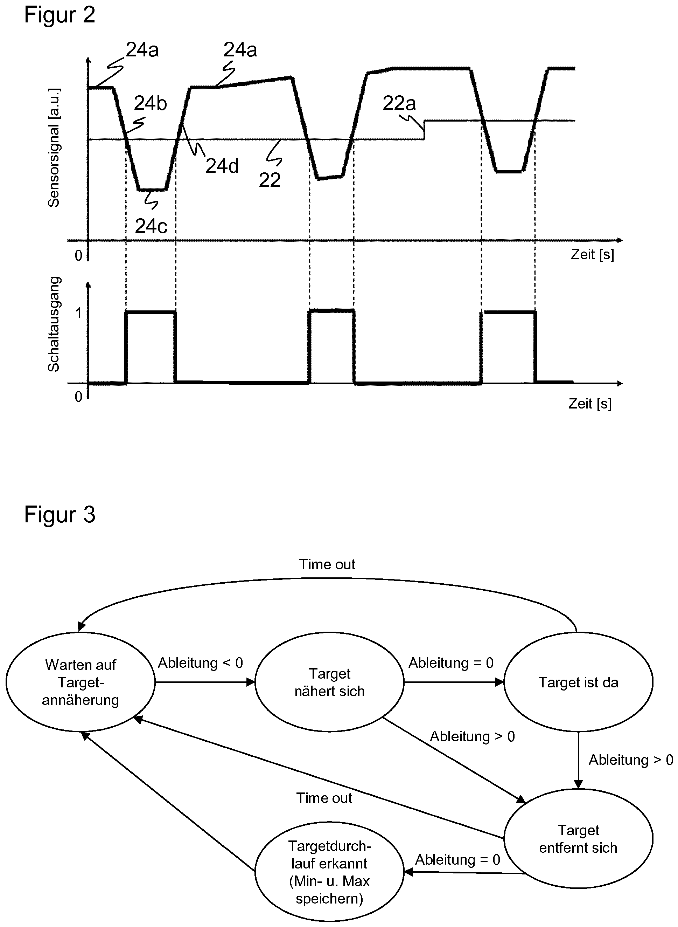

Die Figuren 1a bis 1d zeigen einen typischen sogenannten Targetzyklus, in dem sich ein Zielobjekt 20 auf den Näherungssensor 10 zu und wieder von ihm wegbewegt. Figur 2 stellt im oberen Teil einen beispielhaften zeitlichen Verlauf des Sensorsignals während mehrerer Targetzyklen und im unteren Teil einen zugehörigen zeitlichen Verlauf des Schaltsignals dar. Das Schaltsignal entsteht durch Bewertung des Sensorsignals mit der Schwelle 22, was letztlich eine 1-Bit-wertige Digitalisierung oder Binarisierung bedeutet.

Solange sich wie in Figur 1a kein Zielobjekt 20 in der Nähe befindet, bleibt das Sensorsignal wie in Figur 2 zu erkennen auf einem oberen konstanten Wert, der im Rahmen dieser Beschreibung als Abwesenheitspegel 24a bezeichnet wird. Bei der Annäherung des Zielobjekts 20 wie in Figur 1b werden in dem leitenden, häufig metallischen Zielobjekt 20 Wirbelströme induziert, welche zu einem Absinken der Spannung über der Empfangsspule oder dem Schwingkreis führen. Das Sensorsignal sinkt deshalb umso stärker ab, je näher das Zielobjekt 20 dem Näherungssensor 10 kommt. Deshalb kommt es in dem Sensorsignal der Figur 2 zu einer fallenden Flanke 24b.

In Figur 1c befindet sich das Zielobjekt 20 nur noch in einem Abstand zu dem Näherungssensor 10, der höchstens dem Schaltabstand 16 entspricht. Während das Zielobjekt 20 in diesem Abstand verharrt, bildet sich im Sensorsignal der Figur 2 ein weiterer konstanter Bereich aus, der im Rahmen dieser Beschreibung als Anwesenheitspegel 24c bezeichnet wird. Wenn sich das Zielobjekt 20 anschließend wie in Figur 1d wieder entfernt, kehrt das Sensorsignal in Figur 2 über eine steigende Flanke 24d auf den Abwesenheitspegel 24a zurück, und es schließt sich nach einer gewissen Pause der nächste Targetzyklus an.

Die Bewegung des Zielobjekts 20 kann selbstverständlich anders als dargestellt auch transversal oder mit transversaler Komponente erfolgen. Auch die Beschreibung anhand eines induktiven Näherungssensors 10 soll nur als Beispiel verstanden werden, auf das die Erfindung nicht beschränkt ist. Ein entsprechendes Verhalten des Sensorsignals ergibt sich auch bei anderen elektromagnetischen Näherungssensoren, wie kapazitiven, magnetischen oder Mikrowellensensoren. Allerdings kann es dann sein, dass das Sensorsignal sich gerade umgekehrt verhält, nämlich bei Annäherung des Zielobjekts 20 ansteigt. Die Auswertung und die im Folgenden erläuterte erfindungsgemäße Driftkompensation kann dies durch entsprechende Vorzeichenwechsel berücksichtigen.

Wie einleitend erläutert, ergibt sich ein Problem der Schwellbewertung dadurch, dass die Veränderungen des Sensorsignals durch Annäherung des Zielobjekts 20 von Stör- oder Drifteffekten überlagert sind, was zu Verschiebungen des Schaltabstands 16 und im Extremfall einem Funktionsausfall führt. Erfindungsgemäß wird deshalb die Schwelle 22 angepasst.

Es ist aber möglich, den Einfluss von Driften und Bewegungen des Zielobjekts 20 auf das Sensorsignal zu trennen. Ein Lösungsansatz besteht darin, dass die Driften wesentlich langsamer, wie im Falle von Verschleiß, Alterung, Verschmutzung oder Temperaturänderung, oder wesentlich seltener sind als die Bewegungen des Zielobjekts 20, wie im Falle einer veränderten Einbausituation. Die Auswertungseinheit 14 kann die zeitliche Veränderung des Sensorsignals analysieren, um festzustellen, wann das Zielobjekt 20 abwesend ist und keinen Einfluss auf das Sensorsignal ausübt und wann es anwesend ist. Ein mögliches Ziel dieser Auswertung ist, die Situationen der Figuren 1a beziehungsweise 1c zu erkennen, um den Abwesenheitspegel 24a und/oder den Anwesenheitspegel 24c zu bestimmen. Für diese Analyse ist erforderlich, das sich mit dem Abstand des Zielobjekts 20 verändernde Sensorsignal und nicht lediglich das Schaltsignal zu betrachten. Außerdem kann die Tatsache ausgenutzt werden, dass sich die Drifteffekte unabhängig von der Position des Zielobjekts 20 nahezu identisch auf das Sensorsignal auswirken.

Eine Abwesenheit beziehungsweise Abwesenheit des Zielobjekts 20 kann vorzugsweise durch eine Analyse der Ableitung des Sensorsignals erkannt werden. Ein Targetzyklus, also ein Durchlaufen des Zielobjekts 20 durch einen Erfassungsbereich des Näherungssensors 10 wie in Figur 1a-d illustriert, erzeugt ein charakteristisches Ableitungsmuster. Drifteffekte zeigen dieses Ableitungsmuster nicht, sondern rufen beispielsweise nur eine sehr kleine Ableitung hervor (Temperatur), haben immer das gleiche Vorzeichen (Verschleiß, Alterung) oder tauchen nur als einmaliges Ereignis auf (Einbauveränderung).

Wie anhand Figur 2 nachvollziehbar, wird über einen Targetzyklus die anfänglich konstante Ableitung erst negativ, gefolgt von einem Plateau mit Ableitung Null und einer positiven Ableitung, die wieder auf Null abfällt. Das Muster dieser Abfolge der Vorzeichen der Ableitung kann klar detektiert und von durch Störungen oder Driften verursachten Veränderungen unterschieden werden. Nach Erkennung eines vollständigen Durchlaufs oder Targetzyklus' kann die Auswertungseinheit 14 voraussetzen, dass in diesem Moment das Zielobjekt 20 abwesend ist und demnach der Abwesenheitspegel 24a vorliegt. In Figur 2 ist den schnellen Änderungen des Sensorsignals aufgrund der Bewegung des Zielobjekts 20 beispielhaft eine langsame Drift nach oben überlagert, beispielsweise durch Temperaturänderung. Auch durch die Drift weicht die Ableitung von Null ab, aber durch die beschriebene Erkennung der Abfolge der Vorzeichen wird dies sicher unterschieden.

Figur 3 illustriert eine Möglichkeit, die Analyse der Ableitung in einem Zustandsautomaten zu modellieren und dadurch eine einfache Auswertung zu ermöglichen. Die Zustände und die Bedingungen für Zustandsübergänge sind in Figur 1 und 2 nachvollziehbar. Im ersten Zustand "Warten auf Targetannäherung" befindet sich wie in Figur 1a kein Zielobjekt 20 in der Nähe des Näherungssensors 10, und das Sensorsignal entspricht dem Abwesenheitspegel 24a. Der Übergang in einen zweiten Zustand "Target nähert sich" gemäß Figur 1b erfolgt, wenn in der fallenden Flanke 24b des Sensorsignals die Ableitung negativ wird. Wenn die Ableitung anschließend wieder verschwindet, geht der Zustandsautomat in einen dritten Zustand "Target ist da" gemäß Figur 1c über. In diesem Zustand kann der Anwesenheitspegel gemessen werden. Bei einer positiven Ableitung in der steigenden Flanke 24d erfolgt dann der Übergang in einen vierten Zustand "Target entfernt sich" gemäß Figur 1d. Alternativ gibt es nach dem zweiten Zustand keine messbare Phase, in welcher das Zielobjekt 20 anwesend ist, sondern es entfernt sich unter Auslassung des dritten Zustands sofort, und so geht der zweite Zustand direkt wegen positiver Ableitung in den vierten Zustand über. Der Anwesenheitspegel 24c kann dann als Minimum des Sensorsignals geschätzt werden.

Wenn dann im vierten Zustand die Ableitung erneut verschwindet, ist der Targetzyklus beendet, und der Zustandsautomat kehrt in den ersten Zustand zurück. Zuvor können je nach Bedarf Abwesenheitspegel 24a und/oder Anwesenheitspegel 24c gespeichert werden. Die Rückkehr in den ersten Zustand kann auch durch Abbruch wegen Zeitablauf (time out) erfolgen, wobei dies in Figur 3 beispielhaft für den dritten und vierten Zustand gezeigt ist.

Die Auswertung über einen Zustandsautomaten oder Klassifikator ist einfach und robust. Es sind aber auch alternative Auswertungen beispielsweise durch neuronale Netze denkbar.

Die Kenntnis von Abwesenheitspegel 24a und/oder Anwesenheitspegel 24c ermöglicht eine Anpassung der Schwelle 22 an Drifteffekte, wie dies in Figur 2 an einer Anpassungsstelle 22a beispielhaft illustriert ist. Dazu werden im Folgenden zwei bevorzugte Ausführungsformen näher vorgestellt.

In einem Autokorrekturverfahren (Auto-Correct) soll der Näherungssensor 10 trotz der Driften immer im gleichen Schaltabstand 16 schalten. Dazu wird der Näherungssensor 10 beispielsweise bei Raumtemperatur unter bestimmten Einbaubedingungen montiert und hat in diesem Moment einen für den Anwender akzeptablen Schaltabstand 16. Die Auswertungseinheit 14 bestimmt nun anfänglich und immer wieder, beispielsweise zyklisch in festen Zeitabständen oder nach jedem als vollständig erkannten Targetdurchlauf, den Abwesenheitspegel 24a. Wenn sich dieser Wert gegenüber dem zuvor gespeicherten Wert verändert hat, wird die Schwelle 22 um die Differenz zwischen altem Wert und neuem Wert modifiziert. Zumindest der zuletzt für eine Schwellenanpassung verwendete, beziehungsweise der anfängliche Wert wird für spätere Schwellenanpassungen gespeichert. Die Schwelle 22 kann, muss aber nicht direkt um die jeweilige Differenz der Abwesenheitspegel 24a verändert werden, sondern kann auch noch einen Skalierungsfaktor oder Nichtlinearitäten berücksichtigen.

Mit dem Autokorrekturverfahren wird der Einfluss von Drifteffekten auf die Schaltschwelle nahezu eliminiert, und der Schaltabstand 16 bleibt über die Lebensdauer stets auf dem anfänglich beispielsweise während der Installation eingestellten Wert.

In einem alternativen Autodetektionsverfahren (Auto-Detect) hat der Näherungssensor 10 keinen festen Schaltabstand 16, sondern passt den Schaltabstand 16 immer so an, dass die Anwesenheit eines Zielobjekts 20 mit möglichst großer Störunempfindlichkeit erkannt wird. Dabei wird die Schwelle 22 nicht nur nachgeführt, sondern anhand des Abwesenheitspegels 24a und des Anwesenheitspegels 24c neu festgelegt. Eine beispielhafte robuste Schwellenlage wird dadurch erreicht, dass die Schwelle 22 auf die Mitte zwischen Abwesenheitspegel 24a und Anwesenheitspegel 24c gelegt wird.

Der Näherungssensor 10 hat beim Autodetektionsverfahren das Ziel einer möglichst robusten Erkennung und verzichtet dafür auf einen festgelegten Schaltabstand 16. Der Näherungssensor 10 ermittelt sich einen Schaltabstand 16 sozusagen selbst. Dies hat den Vorteil, dass Einbaueinflüsse direkt nach der Inbetriebnahme automatisch eliminiert werden und auch das Material des Zielobjekts 20 für eine sichere Erkennung keine Rolle spielt. Solche Näherungssensoren 10 brauchen auch nur für einen maximal möglichen und nicht einen festen Schaltabstand 16 ausgelegt werden. Alle Schaltabstände kleiner dem maximal möglichen werden durch ein und dasselbe Gerät mit abgedeckt. Dadurch werden Varianz, Logistik- und Beschaffungsaufwand sowohl beim Hersteller als auch beim Anwender des Näherungssensors 10 erheblich verringert.

## Patentansprüche

1. Elektromagnetischer Näherungssensor (10), insbesondere induktiver Näherungssensor, zur Erfassung eines Zielobjekts (20), der ein Sensorelement (12) zur Erzeugung eines Sensorsignals, das sich mit dem Abstand des Zielobjekts (20) verändert, und eine Auswertungseinheit (14) aufweist, in der durch Vergleich des Sensorsignals mit einer Schaltschwelle (22) die Anwesenheit des Zielobjekts (20) in einem Schaltabstand (16) erkennbar ist, wobei die Auswertungseinheit (14) dafür ausgebildet ist, einen Abwesenheitspegel (24a) des Sensorsignals, während kein Zielobjekt (20) das Sensorsignal beeinflusst, und/oder einen Anwesenheitspegel (24c) des Sensorsignals zu erfassen, während ein Zielobjekt (20) als anwesend erkannt ist, und die Schaltschwelle (22) anhand des Abwesenheitspegels (24a) und/oder des Anwesenheitspegels (24c) anzupassen,
**dadurch gekennzeichnet,**
**dass** die Auswertungseinheit (14) weiterhin dafür ausgebildet ist, Zeitpunkte zur Erfassung des Abwesenheitspegels (24a) und/oder des Anwesenheitspegels (24c) zu bestimmen, indem das Sensorsignal auf eine erwartete zeitliche Abfolge des Vorzeichens der Ableitung des Sensorsignals untersucht wird.

2. Näherungssensor (10) nach Anspruch 1,
wobei das Sensorelement (12) eine Sendespule mit einer Erregerschaltung und eine Empfangsspule umfasst und das Sensorsignal aus der Spannung über der Empfangsspule abgeleitet ist, oder wobei das Sensorelement (12) einen Schwingkreis mit einer Spule aufweist und das Sensorsignal aus der Spannung über dem Schwingkreis abgeleitet ist.

3. Näherungssensor (10) nach Anspruch 1 oder 2,
wobei die Auswertungseinheit (14) dafür ausgebildet ist, die Schaltschwelle (22) entsprechend den Änderungen des Abwesenheitspegels (24a) anzupassen.

4. Näherungssensor (10) nach Anspruch 1 oder 2,
wobei die Auswertungseinheit (14) dafür ausgebildet ist, die Schaltschwelle (22) bei einer Anpassung mit großem Störabstand zu Abwesenheitspegel (24a) und Anwesenheitspegel (24b) neu festzulegen, insbesondere auf deren Mittelwert.

5. Näherungssensor (10) nach einem der vorhergehenden Ansprüche,
wobei die Auswertungseinheit (14) dafür ausgebildet ist, einen zeitlichen Verlauf des Sensorsignals mit einem Referenzverlauf während einer erwarteten Bewegung des Zielobjekts (20) zu vergleichen und so Zeitpunkte zur Erfassung des Abwesenheitspegels (24a) und/oder des Anwesenheitspegels (24c) zu bestimmen.

6. Näherungssensor (10) nach einem der vorhergehenden Ansprüche,
wobei die Auswertungseinheit (14) dafür ausgebildet ist, aus dem Vorzeichen der Ableitung des Sensorsignals Bedingungen für einen Zustandsübergang in einem Zustandsautomaten abzuleiten, wobei in einem ersten Zustand der Abwesenheitspegel (24a) und/oder in einem weiteren Zustand der Anwesenheitspegel (24c) bestimmt wird.

7. Näherungssensor (10) nach Anspruch 6,
wobei der Zustandsautomat den ersten Zustand "Warten auf Targetannäherung", den zweiten Zustand "Target nähert sich", einen dritten Zustand "Target ist da" und einen vierten Zustand "Target entfernt sich" aufweist, mit den Zustandsübergängen
- erster Zustand auf zweiter Zustand bei negativer Ableitung
- zweiter Zustand auf dritten Zustand bei Ableitung Null
- zweiter Zustand auf vierten Zustand bei positiver Ableitung
- dritter Zustand auf vierten Zustand bei positiver Ableitung und
- vierter Zustand auf ersten Zustand bei Ableitung Null.

8. Verfahren zur Erfassung eines Zielobjekts (20), bei dem aus einem Sensorsignal, das sich mit dem Abstand des Zielobjekts (20) verändert, durch Vergleich mit einer Schaltschwelle (22) die Anwesenheit des Zielobjekts (20) in einem Schaltabstand (16) erkannt wird, wobei ein Abwesenheitspegel (24a) des Sensorsignals, während kein Zielobjekt (20) das Sensorsignal beeinflusst, und/oder ein Anwesenheitspegel (24c) des Sensorsignals erfasst wird, während ein Zielobjekt (20) als anwesend erkannt ist, und die Schaltschwelle (22) anhand des Abwesenheitspegels (24a) und/oder des Anwesenheitspegels (24c) angepasst wird,
**dadurch gekennzeichnet,**
**dass** Zeitpunkte zur Erfassung des Abwesenheitspegels (24a) und/oder des Anwesenheitspegels (24c) bestimmt werden, indem das Sensorsignal auf eine erwartete zeitliche Abfolge des Vorzeichens der Ableitung des Sensorsignals untersucht wird.

## Claims

1. An electromagnetic proximity sensor (10), in particular an inductive sensor, for detecting a target object (20), the proximity sensor (10) comprising a sensor element (12) for generating a sensor signal that varies with a distance of the target object (20) and an evaluation unit (14) configured to detect a presence of the target object (20) in a switching distance (16) by comparing the sensor signal with a switching threshold (22), to detect an absence level (24a) of the sensor signal while no target object (12) affects the sensor signal and/or a presence level (24c) of the sensor signal while a target object (20) is detected as present, and to adapt the switching threshold (22) based on the absence level (24a) and/or the presence level (24c),
**characterized in that** the evaluation unit (14) is further configured to determine points in time for the detection of the absence level (24a) and/or the presence level (24c) based on an analysis the sensor signal for an expected temporal sequence of the sign of the derivation of the sensor signal.

2. The proximity sensor (10) in accordance with claim 1,
wherein the sensor element (12) comprises a transmission coil with an exciter circuit and a reception coil, and wherein the sensor signal is derived from a voltage across the reception coil, or wherein the sensor element (12) comprises an oscillator circuit having a coil, and wherein the sensor signal is derived from a voltage across the oscillator circuit.

3. The proximity sensor (10) in accordance with claim 1 or 2,
wherein the evaluation unit (14) is configured to adapt the switching threshold (22) according to variations of the absence level (24a).

4. The proximity sensor (10) in accordance with claim 1 or 2,
wherein the evaluation unit (14) is configured to set a new switching threshold (22) having a large noise margin with respect to the absence level (24a) and the presence level (24c) when adapting the switching threshold (22), in particular as the average of absence level (24a) and presence level (24c).

5. The proximity sensor (10) in accordance with any of the preceding claims,
wherein the evaluation unit (14) is configured to compare a temporal course of the sensor signal with a reference course during an expected movement of the target object (20) and thus to determine points in time for the detection of at least one of the absence level (24a) and the presence level (24c).

6. The proximity sensor (10) in accordance with any of the preceding claims,
wherein the evaluation unit (14) is configured to detect conditions for a state transition in a state machine from the sign of the derivation of the sensor signal, wherein the absence level (24a) in a first state and/or a presence level (24c) in a further state is determined.

7. The proximity sensor (10) in accordance with claim 6,
wherein the state machine comprises a first state "waiting for target approach", a second state "target approaches", a third state "target is present" and a fourth state "target moves away", with the following state transitions:
- first state to second state when the derivation is negative;
- second state to third state when the derivation is zero;
- second state to fourth state when the derivation is positive;
- third state to fourth state when the derivation is positive; and
- fourth state to first state when the derivation is zero.

8. A method for detecting a target object (20), wherein presence of the target object (20) in a switching distance (16) is detected from a sensor signal which varies with a distance from the target object (20) by comparing the sensor signal with a switching threshold (22), wherein there is detected an absence level (24a) of the sensor signal while no target object (20) affects the sensor signal and/or a presence level (24c) of the sensor signal while a target object (20) is detected as present, and wherein the switching threshold (22) is adapted based on the absence level (24a) and/or the presence level (24c),
**characterized in that** points in time for the detection of the absence level (24a) and/or the presence level (24c) are determined based on an analysis of the derivation of the sensor signal based on an analysis the sensor signal for an expected temporal sequence of the sign of the derivation of the sensor signal.

## Revendications

1. Capteur de proximité électromagnétique (10), en particulier capteur de proximité inductif, destiné à détecter un objet cible (20) et comprenant un élément capteur (12) pour générer un signal de capteur qui se modifie au fur et à mesure de la distance de l'objet cible (20), et une unité d'évaluation (14) dans laquelle la présence de l'objet cible (20) à une distance de commutation (16) est reconnaissable par comparaison du signal de capteur à un seuil de commutation (22), l'unité d'évaluation (14) étant conçue pour détecter un niveau d'absence (24a) du signal de capteur lorsqu'aucun objet cible (20) n'affecte le signal de capteur, et/ou un niveau de présence (24c) du signal de capteur lorsqu'un objet cible (20) est reconnu présent, et pour adapter le seuil de commutation (22) en se basant sur le niveau d'absence (24a) et/ou sur le niveau de présence (24c),
**caractérisé en ce que**
l'unité d'évaluation (14) est en outre conçue pour déterminer des instants de détection du niveau d'absence (24a) et/ou du niveau de présence (24c) en analysant le signal de capteur vis-à-vis d'une chronologie attendue du signe de la dérivée du signal de capteur.

2. Capteur de proximité (10) selon la revendication 1,
dans lequel l'élément capteur (12) comprend une bobine émettrice pourvue d'un circuit d'excitation et une bobine réceptrice, et le signal capteur est dérivé de la tension sur la bobine réceptrice, ou l'élément capteur (12) comprend un circuit oscillant pourvu d'une bobine et le signal de capteur est dérivé de la tension sur le circuit oscillant.

3. Capteur de proximité (10) selon la revendication 1 ou 2,
dans lequel l'unité d'évaluation (14) est conçue pour adapter le seuil de commutation (22) en fonction des modifications du niveau d'absence (24a).

4. Capteur de proximité (10) selon la revendication 1 ou 2,
dans lequel l'unité d'évaluation (14) est conçue pour nouvellement déterminer le seuil de commutation (22) lors d'une adaptation à rapport signal/bruit élevé du niveau d'absence (24a) et du niveau de présence (24b), en particulier sur leur valeur moyenne.

5. Capteur de proximité (10) selon l'une des revendications précédentes, dans lequel l'unité d'évaluation (14) est conçue pour comparer une évolution temporelle du signal de capteur à une évolution de référence pendant un mouvement attendu de l'objet cible (20) et pour déterminer ainsi des instants de détection du niveau d'absence (24a) et/ou du niveau de présence (24c).

6. Capteur de proximité (10) selon l'une des revendications précédentes, dans lequel l'unité d'évaluation (14) est conçue pour dériver à partir du signe de la dérivée du signal de capteur, des conditions relatives à une transition d'état dans un automate d'état, en déterminant dans un premier état le niveau d'absence (24a) et/ou dans un autre état le niveau de présence (24c).

7. Capteur de proximité (10) selon la revendication 6,
dans lequel l'automate d'état présente le premier état "attendre une approche de la cible", le second état "cible s'approche", un troisième état "cible est là" et un quatrième état "cible s'éloigne", avec les transitions d'état
- du premier état vers le second état lors d'une dérivée négative
- du second état vers le troisième état lors d'une dérivée nulle
- du second état vers le quatrième état lors d'une dérivée positive
- du troisième état vers le quatrième état lors d'une dérivée positive et
- du quatrième état vers le premier état lors d'une dérivée nulle.

8. Procédé de détection d'un objet cible (20), dans lequel on reconnaît la présence de l'objet cible (20) à une distance de commutation (16) à partir d'un signal de capteur qui se modifie au fur et à mesure de la distance de l'objet cible (20), par comparaison à un seuil de commutation (22), en détectant un niveau d'absence (24a) du signal de capteur lorsqu'aucun objet cible (20) n'affecte le signal de capteur, et/ou un niveau de présence (24c) du signal de capteur lorsqu'un objet cible (20) est reconnu présent, et dans lequel on adapte le seuil de commutation (22) en se basant sur le niveau d'absence (24a) et/ou sur le niveau de présence (24c),
**caractérisé en ce que**
on détermine des instants de détection du niveau d'absence (24a) et/ou du niveau de présence (24c) en analysant le signal de capteur vis-à-vis d'une chronologie attendue du signe de la dérivée du signal de capteur.
